(19) Europäisches Patentamt

European Patent Office

Office européen des brevets

(11)    **EP 1 260 823 B1**

(12)    **EUROPÄISCHE PATENTSCHRIFT**

(45) Veröffentlichungstag und Bekanntmachung des Hinweises auf die Patenterteilung:
**05.04.2006   Patentblatt 2006/14**

(51) Int Cl.:
***G01R 31/333*** *(2006.01)*

(21) Anmeldenummer: **01250178.9**

(22) Anmeldetag: **20.05.2001**

(54) **Synthetische Schaltleistungsprüfschaltung für Hochspannungswechselstrom-Leistungsschalter**

Synthetic making/breaking capacity test circuit for high-voltage alternating-current circuit-breakers

Circuit d'essai synthétique pour vérifier la capacité de fermeture/coupure des disjoncteurs à haute tension à courant alternatif

(84) Benannte Vertragsstaaten:
**AT BE CH CY DE DK ES FI FR GB GR IE IT LI LU MC NL PT SE TR**

(43) Veröffentlichungstag der Anmeldung:
**27.11.2002   Patentblatt 2002/48**

(73) Patentinhaber: **Slamecka, Ernst**
**13595 Berlin (DE)**

(72) Erfinder: **Slamecka, Ernst**
**13595 Berlin (DE)**

(56) Entgegenhaltungen:
**DE-A- 1 541 852          DE-A- 1 616 035**
**DE-B- 2 528 100          GB-A- 1 242 400**

**Beschreibung**

Die Erfindung bezieht sich auf synthetische Schaltleistungsprüfschaltungen mit den im Oberbegriff des Patentanspruchs 1 genannten Merkmalen. Eine synthetische Ausschaltleistungsprüfschaltung dieser Art ist durch DE 962 731, Anmeldetag: 03.04.42, Erfinder: Fritz Weil, bekannt.

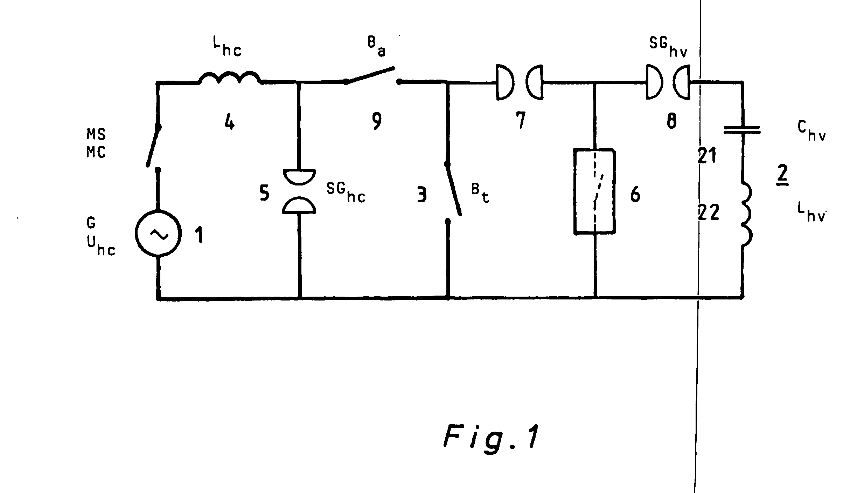

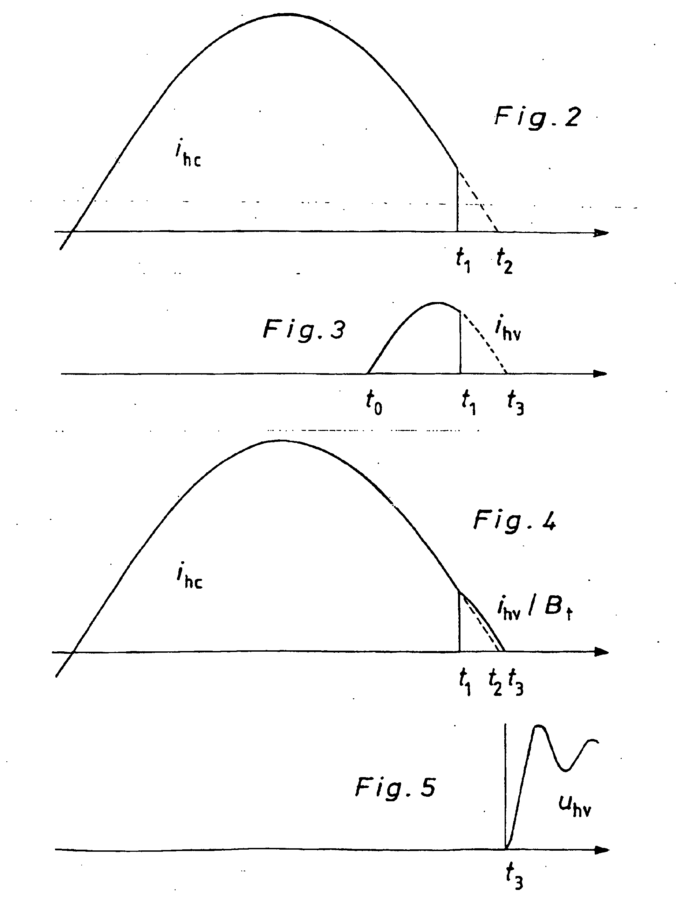

Im funktionell nach dem Original, Fig. 3, gezeichneten Schaltplan, Fig. 1, sind die originalen Bezugszeichen durch international eingeführte Zeichen für die durch Symbole dargestellten Stromkreiselemente ergänzt.

Im Hochstromkreis fließt zunächst durch die Reihenschaltung von Hilfsschalter $9/B_a$ und Prüfschalter $3/B_t$ eine Hälbschwingung des Hochstroms $i_{hc}$, Fig. 2, von einem Generator G gespeist. Der Hochspannungskreis ist bei offener Schaltfunkenstrecke $8/SG_{hv}$ noch nicht in Betrieb, und außerdem ist er durch die offene Funkenstrecke 7 auch noch vom Hochstromkreis getrennt.

Im Zeitpunkt $t_0$, Fig. 3, wird der Hochspannungsschwingkreis mit der auf elektrisches Potential aufgeladenen Kapazität $21/C_{hv}$ durch Zünden der Schaltfunkenstrecke $8/SG_{hv}$ geschlossen. Daraufhin fließt eine Schwingstrom-Halbschwingung $i_{hv}$ über einen "Unterbrecher 6 mit hohem Spannungsabfall". Der Zeitpunkt $t_0$ ist so gwählt, daß der Nulldurchgang der Halbschwingung des Schwingstroms kurz nach dem Nulldurchgang des Hochstroms, Zeitpunkt $t_2$, im Zeitpunkt $t_3$ erfolgt. Im Zeitpunkt $t_1$ "größter Übereinstimmung beider Ströme" - in Fig. 2, 3 bei einem relativen Momentanwert des Schwingstroms von $i_{hv}/\hat{I}_{hv}$ gleich 0,87, entsprechend 120° Phasenlage - "sind Mittel vorgesehen, den Hauptstrom von der Prüfschaltstelle fortzunehmen und den Strom der Hochspannungsquelle über die Prüfschaltstelle zu leiten.", Fig. 3, 4. An den Nulldurchgang des Stroms der Hochspannungsquelle schließt die wiederkehrende Spannung $u_{hv}$ der Hochspannungsquelle an, Fig. 5.

Die Stromverläufe der Graphen in den Fig. 2, 3, 4 wurden unter Vernachlässigung der Lichtbogenspannung des Schalters ermittelt, was auch für die weiteren Graphen von Stromverläufen zütrifft.

Das tatsächliche Umleiten des Hochspannungsschwingstroms aus dem anfänglich außerhalb des Hochstromkreises in Betrieb gesetzten Hochspannungsschwingkreises in den im Hochstromkreis befindlichen Prüfschalter als Folgestrom des synchron zu eliminierenden Hochstroms dürfte das erhebliche Problem dieser synthetischen Prüfschaltung darstellen.

Der die Erfindung veranlassende Stand der Technik war für F. Weil: "... bekannte Prüfanordnung hat den Nachteil, daß der Verlauf des Hauptstroms kurz vor seinem Nulldurchgang, bzw. der Einsatz der Hochspannung als Wiederkehrspannung nicht den Verhältnissen der natürlichen Prüfung entspricht. Dies ergibt sich daraus, daß die Hochspannungsquelle bereits vor dem Nulldurchgang des Hauptstroms auf die Prüfschaltstelle geschaltet ist, so daß sich beide Ströme in der Schaltstelle überlagern und einen zu hohen Wert ergeben." Der Schaltplan dieser "Prüfanordnung" ergibt sich elementar durch Rückbildung des Schaltplans der Weil-Schaltung, Fig. 1, bzw. 3.

Dabei handelt es sich um eine synthetische Prüfschaltung bekannt gewesen in der "AEG-Transformatorenfabrik (Berlin) Oberschöneweide" unter der Bezeichnung "Kunstschaltung" (J. Biermanns); große Namen in:der Hochspannungstechnik und Schalterphysik wie G. Stern, J. Biermanns, 0. Mayr erinnern an diese heute nicht mehr existierende Fabrik mit dem Weltersten Hochleistungsprüffeld (1912), und dort arbeitete auch F. Weil.

Der vorstehend auszugsweise zitierte, der Weil-Schaltung zugrunde liegende Stand der Technik ist Thema der Patentschrift DE 975 303, "Zusatz zum (Weil-) Patent 962 731", Anmeldetag: 02.04.50, Autor: Günther Dobke.

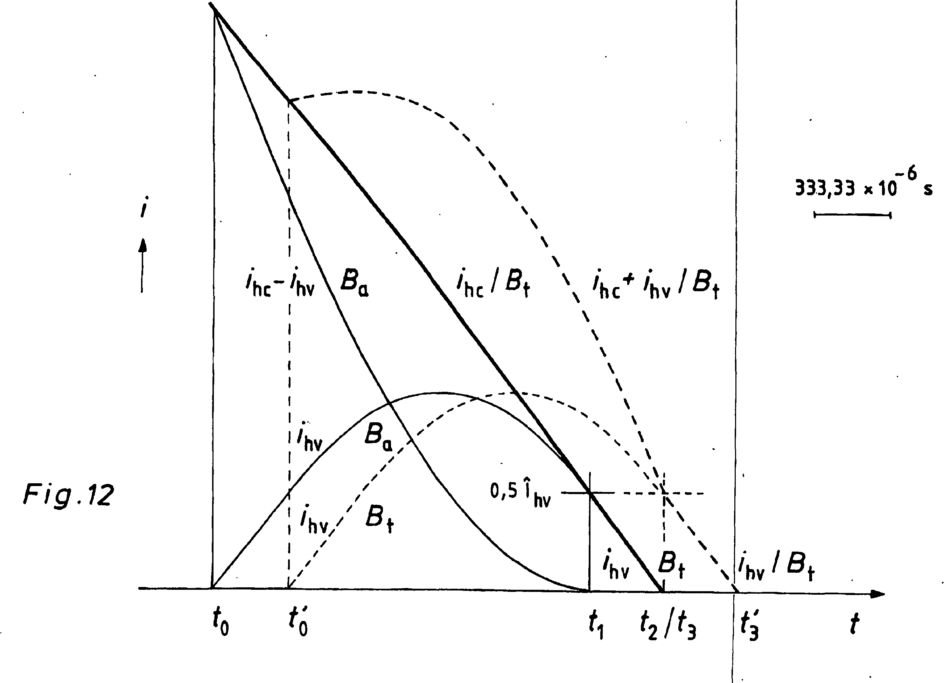

Wie von F. Weil bereits zutreffend angeführt, ergibt Überlagern von Hauptstrom und Strom der Hochspannungsquelle in der Schaltstrecke des Prüfschalters einen erheblich verzerrten synthetischen Strom im Vergleich mit einem homogenen, sinusförmigen Strom, Fig. 2b, 2a. Auch bei auf physikalisch korrekten Annahmen zum Schwingstromfluß beruhender graphischer Ermittlung des synthetischen Stromverlaufs im Prüfschalter ist die Stromverzerrung noch deutlich erkennbar: "Untersuchungen über die AEG-Prüfschaltung für Hochleistungsschalter", E. Slamecka, Dissertationsschrift Technische Hochschule Graz 1955 und IEC-Publication 60427, Third edition 2000-04, page. 95, Figs. BB.1, BB.2: Siehe auch Fig. 12, Graph mit gestricheltem Linienzug.

Eine synthetische Prüfschaltung mit ausschließlicher Stromfolge im Prüfschalter und mit einem Hochspannungsschwingkreis, der während der Betriebszeit von einer Parallelschaltung zum Hilfsschalter in eine Reihenschaltung mit Hochstromquelle und Prüfschalter wechselt ist bekannt durch: IEC-Publication 60427, Third edition 2000-04, page 97, Figs. BB.3, BB.4.

Eine genauere Untersuchung zeigt eine relativ erhebliche Komplexität dieser synthetischen Ausschaltleistungsprüfschaltung in Berechnung und Handhabung. Hinzu kommt noch ein.anderes Problem: bei einem Spannungsdurchschlag der Schaltstrecke des Prüfschalters - kein seltenes Ereignis in der Entwicklungsphase eines Hochspannungsschalters - wird die Isolation des Hochstromkreises mit der Spannung des Hochspannungsschwingkreises stoßartig beansprucht.

Zur Kostenbegrenzung ist bekannt, bei synthetischen Ausschaltleistungsprüfschaltungen mit synthetischem Strom dem Nulldurchgang dieses Stroms eine synthetische Einschwingspannung folgen zu lassen und zu diesem Zweck mittels eines zweiten Hilfschalters einen zweiten Hochspannungsschwingkreis einzuführen.

In der DE 19 38 872 ist der erste Hochspannungsschawingkreis dem Prüfschalter zunächst parallelgeschaltet mit Strom- Überlagerung und Folge in dessen Schaltstrecke; der zweite Hilfsschalter befindet sich in einem Stromleiterabschnitt des ersten Hochspannungsschwingkreises.

In der DE 25 28 100 ist der erste Hochspannungsschwingkreis dem ersten Hilfsschalter zunächst parallelgeschaltet mit Wechsel zu Reihenschaltung mit Prüfschalter und Hochstromquelle; der zweite Hilfsschalter ist in einem Stromleiterabschnitt des Hochstromkreises angeordnet.

In beiden synthetischen Zweikreis- Prüfschaltungen sind die bereits dargelegten spezifischen Probleme ihrer synthetischen Basisschaltungen weiter präsent.

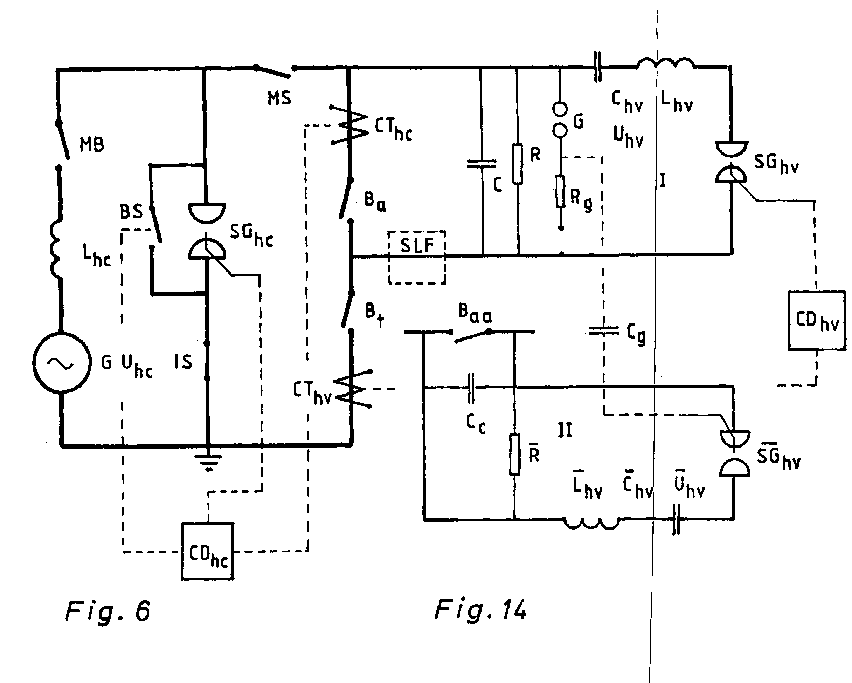

Eine synthetische Prüfschaltung zum Prüfen der Einschaltleistung eines Hochspannungs- Wechselstrom- Leistungsschalters ist durch die IEC-Publication 60427, Third edition 2000-04, page 59, Fig. 6 bekannt. Dabei wird eine Hochstrom-Schaltfunkenstrecke verwendet zum elektronischen Durchschalten der Hochstromquelle zum Prüfschalter nach dem Vorüberschlag in dessen Schaltstrecke durch die Spannung der Hochspannungsquelle, damit dem Vorüberschlagsstrom der Hochstrom folgen kann. Diese Schaltfunkenstrecke ist mit einer einzigen Funktion in einer synthetischen Prüfschaltung technisch-wirtschaftlich zu wenig ausgenützt.

Als Erfindungsprobleme stellen sich: zunächst Realisierung einer dem Nundurchgang des Kurzschlußstroms pausenlos folgenden Einschwing-Hochspannung an der Schaltstrecke des Prüfschalters in einem-Hochstromkreis mit Hilfsschalter mittels eines mit dem Hochstromkreis durch Schwingstromeinspeisung kooperierenden Hochspannungsschwingkreises und Transfers dieses Schwingstroms in bestimmter Phasenlage parameterkonstant als Folgestrom des Hochstroms in den Prüfschalter; weiterhin: Wahrnehmen erfindungsinhärenten Verbesserungspotentials und Umsetzen in neue Technik. Diese Erfindungsprobleme werden durch den Haupanspruch 1 und die Nebenansprüche 4, 7 gelöst. Vorteilhafte Weiterbildungen von Haupt- und Nebenansprüchen sind in Unteransprüchen beschrieben.

Das Wesentliche und Vorteilhafte der in den Haupt- und Nebenansprüchen gekennzeichneten technischen Lösungen der Erfindungsprobleme besteht in folgendem:

Hauptproblemlösung

- Hochspannungsschwingkreis (I) durch Zünden der Funkenstrecke ($SG_{hv}$) dem Hilfsschalter ($B_a$) parallelgeschaltet kurz vor Hochstrom-Nulldurchgang und Schwingstrom ($i_{hv}$) dem Hochstrom ($i_{hc}$) mit entgegengesetzter Polarität überlagert

- im künstlichen Strom-Nulldurchgang zündet Funkenstrecke ($SG_{hc}$) bewirkend: Kurzschließen der Hochstromquelle (G), Reihenschaltung Hochspannungsschwingkreis (I) strukturkonstant mit Prüfschalter ($B_t$), Schwingstrom aus Hilfsschalter parameterkonstant wechselnd in Prüfschalter dem eliminierten Hochstrom folgend

- auf Nulldurchgang des synthetischen Stroms mit Hochstrom- und Schwingstrom-Folgestromanteil im Prüfschalter folgt pausenlos homogene Spannung des Hochspannungsschwingkreises

Rationalisierungseffekte

- Transformator im Hochstromkreis eingespart: Ergebnis schalttechnisch reduzierter Lichtbogenspannung und eliminierten Überspannungsrisikos für Generator, gegebenenfalls Niederspannungsgenerator einsetzbar

- Hochstromschaltfunkenstrecke zweifach genutzt in synthetischer Generalprüfschaltung für Kurzschlußstrom- Einschalt- und Ausschaltprüfungen in Ein- Aus- Schaltzyklus

- bei sehr hohen Nennspannungen des Prüfschalters Nachbildung der Einschwingspannung durch Spannungsüberlagerung , ($u_{hv}+ \bar{u}_{hv}$) mittels der Hochspannungsschwingkreise (I) und (II) entsprechend Hochstromnachbildung durch Stromfolge ($i_{hc}/i_{hv}$) mittels Hochstromkreises und Hochspannungsschwingkreises (I)

- synthetische Prüfschaltung Hochstrom und Einschwing-Hochspannung erwiesen identisch nachbildend erspart-aufwendige Vergleichsversuche

Anhand der Zeichnungen zu den Ausführungsbeispielen, Fig. 6 bis 22 werden die Erfindungsproblemlösungen näher erläutert; es zeigen:

Stand der Technik gemäß DE 962 731

Fig. 1: Schaltplan mit Hochstromkreis und Hochspannungsschwingkreis nach Original Fig. 3

Fig. 2: Hochstrom-Halbschwingung im Prüfschalter bis zur Eliminierung durch Generator-Kurschluß

Fig. 3: Schwingstrom im noch außerhalb des Hochstromkreises befindlichen Hochspannungsschwingkreis

Fig. 4: Hochstrom-Halbschwingung mit in den Prüfschalter gewechselten Schwingstrom

Fig. 5: Einschwingspannung des Hochspannungsschwingkreises nach Nulldurchgang der Schwingstrom-Halbschwingung

Zeichnungen zu Ausführungsbeispielen

Fig. 6: Schaltplan synthetischer Ausschaltleistungs-prüfschaltung mit Hochstromkreis und Hoch-spannungsschwingkreis I

Fig. 7: Hochstrom-Halbschwingung im Hilfsschalter mit überlagertem Schwingstrom bis zum künstlichen Nulldurchgang

Fig. 8: Schwingstromfluß im Hilfsschalter bis zum Wechsel in den Prüfschalter

Fig. 9: Einschwingspannung des Hochstromkreises bis zur Zündung der Hochstrom-Schaltfunkenstrecke

Fig. 10: Synthetische Stromhalbschwingung im Prüfschalter

Fig. 11: Einschwingspannung des Hochspannungs-schwingkreises synthetischer Strom-Halb-schwingung nachfolgend

Fig. 12: voller Linienzug: Schwingstrom-Überlagerung im Hilfsschalter, Schwingstromfolge im Prüfschalter, AER = 0,98 unterbrochener L.Z.: Schwingstrom- Überlagerung und Folge im Prüfschalter, AER = 1,12

Fig. 13: Lichtbogenenergieverhältnis, AER, als Funktion der Folgestromdauer, SCD, voller L.Z.: Schwingstrom als Folgestrom, unterbrochener L.Z.: Schwingstrom als Überlagerungs- und Folgestrom

Fig. 14: Schaltplan Hochspannungsschwingkreis II

Fig. 15: Einschwingspannung $u_{hv}$, Hochspannungs-schwingkreis I

Fig. 16: Einschwingspannung $\overline{u}_{hv}$, Hochspannungs-schwingkreis II

Fig. 17: Synthetische Einschwingspannung durch Überlagern der Einschwingspannungen der Hochspannungsschwingkreise I und II

Fig. 18: Schaltplan synthetische Einschaltleistungs-Prüfschaltung, Hochstrom-Schaltfunkenstrecke in Zwei-Elektroden-Version

Fig. 19: Einschaltspannung $u_m$, dielektrische Ein-schaltcharakteristik $u_d$ des Prüfschalters, Lichtbogenspannung $u_a$

Fig. 20: Vorüberschlagstrom $i_{im}$, Hochstrom $i_{hc}$ als Überlagerungs- und Folgestrom im Prüfschalter, Zündverzögerug $t_d$ der Funkenstrecke

Fig. 21 Stationärer Hochstrom $i_{hc}$, Verklinkungsinter-vall $t_1$ bis $t_2$

Fig. 22: Schaltplan synthetische Einschaltleistungs-Prüfschaltung, Hochstrom-Schaltfunkenstrecke in Drei-Elektroden-Version

Der Hochstromkreis. Fig. 6, enthält im wesentlichen: einen Generator G als Hochstromquelle, mit oder ohne nachgeschaltetem Transformator, mit der Induktivität $L_{hc}$ (inductance high current) die gegebenenfalls noch eine zusätzliche Strombegrenzungsinduktivität mit-trepräsentieren kann, einen Sicherheitsschalter MB (master circuit-breaker), einen Draufschalter MS (making switch), einen Hilfsschalter $B_a$ (auxiliary circuit-breaker) und einen Prüfschalter $B_t$ (test circuit-breaker).
Der Hochspannungsschwingkreis I enthält im wesentlichen: eine auf hohes elektrisches Potential auf-ladbare Kapazität $C_{hv}$ (capacitance high voltage) als Hochspannungsquelle, eine Induktivität $L_{hv}$ (inductance high voltage), eine Schaltfunkenstrecke $SG_{hv}$ (sparc gap high voltage) und evtl. einen Hochspannungs-Freileitungsabschnitt oder dessen Nachbildung SLF (short-line-fault circuit) für die entsprechenden Prüfungen.
Hochstromkreis und Hochspannungskreis I arbeiten zur Prüfung der Ausschaltleistung wie folgt zusammem:

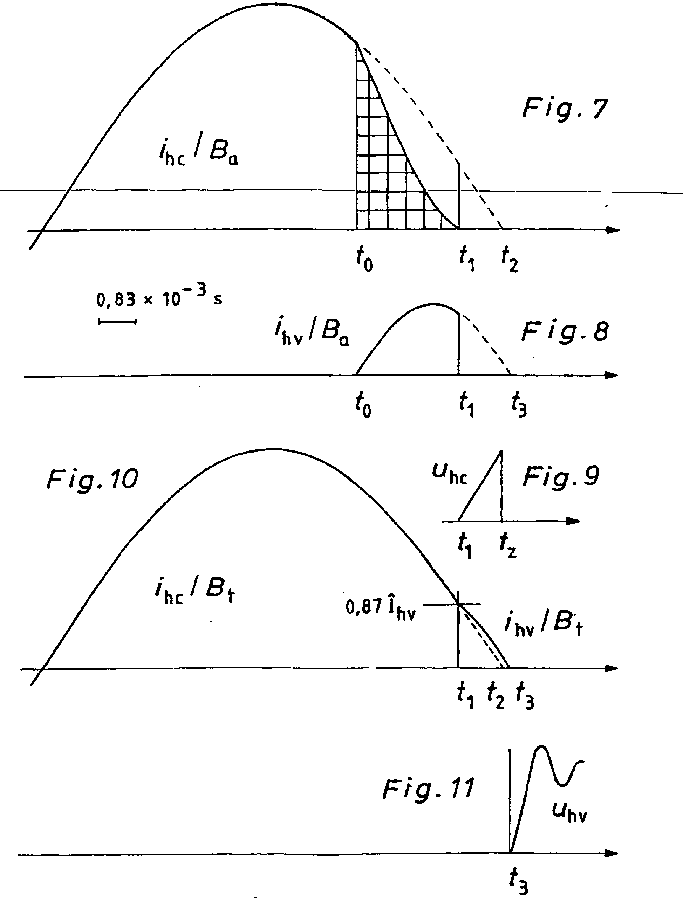

Der Hochspannungsschwingkreis I ist bei noch of-fener Schaltfunkenstrecke dem Hilfsschalter paral-lelgeschaltet. Die Schalter MB, $B_a$, $B_t$ sind geschlos-sen. Der Draufschalter MS schaltet den Hochstrom $i_{hc}$ z.B. ohne Gleichstromglied ein, Fig. 7, 10. Vor dem Nulldurchgang de, Lichtbogen-Halbschwingung des Hochstroms in nach Erhalt von Ausschaltkommandos öffnenden, Hilfs-und Prüfschalter zündet eine an einen Stromwandler $CT_{hv}$ (current trans-former high voltage) angeschlossene Zündvorrich-tung $CD_{hv}$ (control device high voltage) die Schalt-funkenstrecke $SG_{hv}$ im Zeitpunkt $t_0$, Fig. 7, 8. Ein Schwingstrom $i_{hv}$, Fig. 8, überlagert sich dem Hochstrom $i_{hc}$ mit entgegengesetzter Polarität, Fig. 7. Im Nulldurchgang des resultierenden Stroms, Zeitpunkt $t_1$, Fig. 7, Momentanwert des Schwingstroms gleich 0,87 $I_{hv}$, ≡ 120.Grad Phase, Fig. 8, URterbricht der Hilfsschalter diesen Strom. Die Spannung $u_{hc}$ des Hochstromgenerators G schwingt mit einer relativ sehr hohen Frequenz von z.B. 13 kHz auf den stationären Verlauf ein mit einem Anfangswert gemäß dem künstlichen Nulldurchgang des Stroms.

Während des Anstiegs der Einschwingspannung des Hochstromgenerators, z.B. bei 30 kV, zündet die Hochstrom-Schaltfunkenstrecke $SG_{hc}$ (sparc gap high current) im Zeitpunkt $t_z$, Fig. 9. Damit wird der Hochspannungsschwingkreis I unverändert in seiner Struktur in Reihe zum Prüfschalter $B_t$ geschaltet und der Hochström daraus eliminiert. Synchron wechselt der Schwingstrom parameterkonstant als Folgestrom in den Prüfschalter und im nächsten Nulldurchgang, Zeitpunkt $t_3$, Fig. 10, den er zumindest angenähert mit derselben Steilheit erreicht wie ihn der nachzubildende homogene Hochstrom erreichen würde, schwingt die Spannung $u_{hv}$ des Hochspannungsschwingkreises I an der sich dielektrisch regenerierenden Schaltstrecke des Prüfschalters auf einen stationären Wert ein, Fig. 11. Mit der Kapazität C und dem ohmschen Widerstand R an den Klemmen des Prüfschalters - auch andere Schaltverbindungen von C und R als die hier gezeigten sind ausführbar - kann die Einschwingspannung $u_{hv}$ einem etwa durch internationale Empfehlungen vorgegebenem Verlauf angepaßt werden. Für eine Prüfung der Ausschaltleistung unter den Bedingungen eines Abstandkurzschlusses kann die Freileitungsnachbildung SLF in einen Stromleiterabschnitt des Hochspannungsschwingkreises I eingefügt werden.

In einer Variante wechselt der Schwingstrom vom Überlagerungsstrom im Hilfsschalter, $i_{hv}/B_a$, Fig. 7, zum Folgestrom im Prüfschalter, $i_{hv}/B_t$, Fig. 10, bei $(i_{hv} = i_{hc})t_1 = 0,5\,\hat{I}_{hv} \triangleq 150$ Grad Phasenlage, Fig. 12. Die zugehörigen Ströme und Frequenzen verhalten sich wie

$$\hat{I}_{hv} : \hat{I}_{hc} = 1 : 5,$$
$$f_{hv} : f_{hc} = 5 : 1.$$

Dazu errechnet sich eine Phasendifferenz der Nulldurchgänge von synthetischem Strom und fiktivem homogenem Strom zu $(t_3 - t_2) = 14{,}49\ \mu s$. Die stromlose Regenerationszeit $t_1$ bis $t_3$ für den Hilfsschalter errechnet sich zu $333{,}33\ \mu s$.

Während des Stromüberlagerungsintervalls im Hilfsschalter verläuft der resultierende Strom weit unterhalb des zugehörigen sinusförmigen Hochstromverlaufs. Die Lichtbogenenergie ist bei angenommen konstanter Lichtbogenspannung proportional der Fläche unterhalb des resultierenden Stromverlaufs, Fig. 12, und in Fig. 7 durch Karos hervorgehoben. Die Rechnung ergibt eine Reduktion der Lichtbogenenergie um rund 40 %.

Erfolgt die Kontakttrennung des Hilfsschalters erst zu Beginn des die Lichtbogenenergie in der Schaltstrecke des Hilfsschalters reduzierenden Stromüberlagerungsintervalls, fördert das ganz erheblich die Regeneration der Spannungsfestigkeit in der dem Stromnulldurchgang folgenden stromlosen und praktisch auch spannungslosen Pause von $t_1$ bis $t_3$. Fig. 1.0, 12; der Hilfsschalter hält in gleicher Zeit einer höheren Einschwingspannung stand.

Bei einem Hilfsschalter z.B. mit Mehrfachunterbrechung kann daraufhin die Anzahl der Unterbrechereinheiten verk nert werden. Damit verkleinert sich die resultierende Lichtbogenspannung im Hochstromkreis, z.B. um etwa die Hälfte, und in weiterer Konsequenz ihre Auswirkung auf die letzte Halbschwingungdes Hochstroms: Reduktion der Amplitude und Flußdauer. Die treibende Spannung des Hochstromkreises kann dann herabgesetzt werden, z.B. von 36 kV auf 19 kV, was praktisch bedeutet: Einsparen der Hochstrom-Transformatoren. Im Fall der Prüfung von Mittel- und Hochspannungs-Vakuumschaltern wird ein Niederspannungs-Hochstromgenerator anwendbar oder eine technisch wirtschaftlich optimierte Kombination aus Generator und Abspann-Transformator zur Erzeugung des Hochstroms auf Niederspannungspotential.

Vorteilhaft ist es auch, den Hilfsschalter so auszulösen, daß die Kontakte im Zeitpunkt der Trennnug bereits eine Relativgeschwindigkeit besitzen. Bei Schaltern mit Stumpfkontakten wird zu diesem Zweck an Stelle des feststehenden Kontakts ein Nachlaufkontakt (sequential contact) verwendet.

Sollte bei höherer Frequenz des Hochspannungs-Schwingstroms $i_{hv}$ das Zeitintervall von $t_o$ über $t_1$ bis $t_3$ zu kurz sein für das Erreichen der sicheren Löschentfernung der Kontakte des Hilfsschalters, kann die Kontakttrennung eine kurze Zeit gegenüber $t_o$ vorgezogen werden.

Und wenn bei einer relativ niedrigen Frequenz des Schwingstroms das Zeitintervall von $t_o$ bis $t_3$ länger ist als für das Erreichen der sicheren Löschentfernung der Kontakte notwendig, kann die Kontakttrennung gegenüber $t_o$ eine kurze Zeit später stattfinden.

Als Hilfsschalter eignen sich Druckgasschalter oder Vakuumschalter mit relativ zum Prüfschalter wie angegeben reduzierter Schaltlichbogenenergie. Die Vakuumschalter sind mit scheibenförmigen Stumpfkontakten ausgestattet oder sie besitzen allgemein schalenförmige Kontaktanordnungen mit Windungsabschnitten zum Erzeugen eines radialen oder axialen Magnetfeldes.

Zum Vergleich ist noch der Stromverlauf bei der syntheticshen Prüfschaltung mit Stromüberlagerung und Stromfolge im Prüfschalter dargestellt, Fig. 12, unterbrochener Linienzug: Im Zeitpunkt $t_o'$ setzt der Schwingstrom als Überlagerungsstrom im Prüfschalter, $i_{hv}/B_t$, ein. Nach der Stromunterbrechung des Hilfsschalter, Zeitpunkt $t_2$, fließt der Schwingstrom, beginnend auch mit $(i_{hv}B_t)_{t2} = 0{,}5\,\hat{I}_{hv}$, als Folgestrom im Prüfschalter, $i_{hv}/B_t$, weiter. Der Nulldurchgang findet im Zeitpunkt $t_3'$ statt.

Die Phasendifferenz der Nulldurchgänge von synthetischem Hochstrom, $t_3'$, und homogenem Hochstrom, $t_2$, ergibt sich direkt zu $333{,}33\ \mu s$, und sie gleicht der Folgestromdauer.

Offensichtlich ist der synthetische Hochstrom aus Stromüberlagerung und Stromfolge gegenüber dem homogenen Hochstrom erheblich verzerrt.

Vermutlich erhöht sich durch diese Stromverzerrung die thermoenergetische Beanspruchung der Schaltstrecke des Prüfschalters auch in einem erheblichen Ausmaß.

Für eine Aussage über die Äquivalenz der Beanspruchung des Prüfschalters in der erfindungsgemäßen synthetischen Prüfschaltung mit dessen Beanspruchung in einer direkten Prüfschaltung wird die während der Flußdauer des Folgestroms, $t_1$ bis $t_3$, Fig. 12, in der Schaltstrecke freigesetzte Lichtbogenenergie ermittelt und bezogen auf die Lichtbogenenergie eines homogenen Hochstroms gleicher Flußdauer bis zum Nulldurchgang; dabei wird die Lichtbogenspannung als konstant und in beiden Fällen gleich groß angenommen.

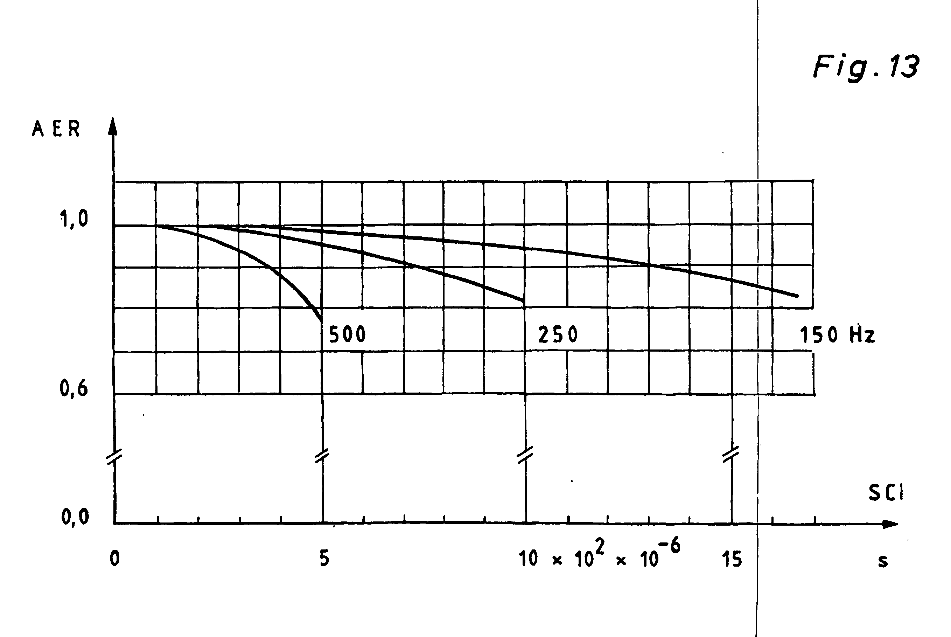

Das Verhältnis dieser Lichtbogenenergien, AER, (arc energies ratio) als Funktion der Folgestromdauer, SCI, (sequence current intervall) - letzteres abhängig vom gewählten Transitwert des Schwingstroms - zeigt die Graphik, Fig. 13; die zu den. AER-Kurven eingetragenen Zahlenwerte sind die Frequenzen der zugrunde gelegten Schwingströme.

Mit abnehmender Dauer des Schwingstroms als Folgestrom nähern sich die AER-Kurven dem Äquivalenzwert 1, und erreichen diesen praktisch, wenn der Folgestrom mit 50 % seines Scheitelwerts startet.

Zur Entlastung der Schaltfunkenstrecke $SG_{hc}$ vom Hochstromlichtbogen ist vorteilhafter Weise ein Überbrückungsschalter BS (bridging switch) eingesetzt, Fig. 6, in Verbindung mit einem Nullpotential ZP (zero potential) aufweisenden Stromleiterabschnitt.

Die Prüfung der Kurzschlußstrom-Schaltleistung eines Hochspannungs-Wechselstrom-Leistungsschalters umfaßt, z.B. gemäß Darlegung in der bereits zitierten IEC-Publication 60427, u.a. das Einschalten auf einen Kurzschluß unmittelbar gefolgt vom Ausschalten des Kurzschlußstroms: "C(lose)0(pen)"-Schaltzyklus. Beim Einschalten des Sicherheitsschalters MB würde die Spannung des Hochstromgenerators bei noch offenem Prüfschalter die Schaltfunkenstrecke $SG_{hc}$ unerwünscht zünden. Dagegen ist in der Verbindungsleitung dieser Schaltfunkenstrecke mit Nullpotential ein Isolierschalter IS (isolating switch) eingebaut und wie folgt gesteuert in Betrieb:

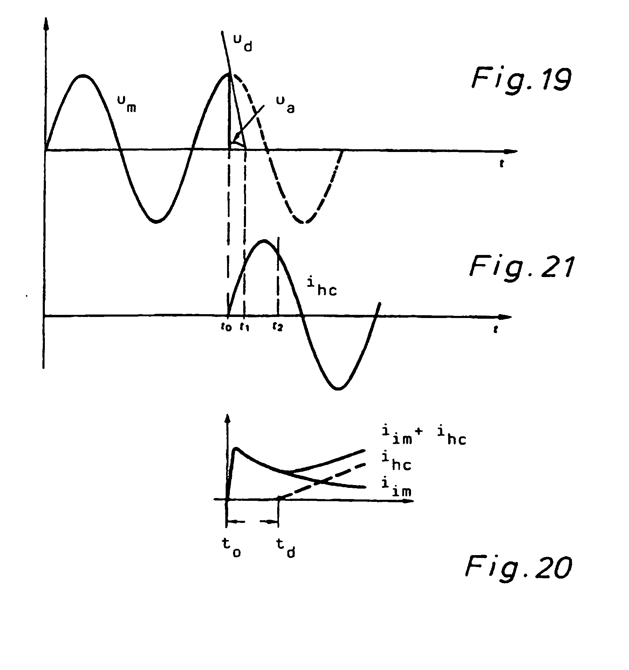

- geöffnet vor und während des Einschalt-Prüfintervalls mit anstehender Einschaltspannung und folgendem Vorüberschlagsstrom, Fig. 19, 20

- geschlossen frühenstens bei Kontaktverklinkung des Prüfschalters , Fig. 21, und weiter noch bis kurz nach der Unterbrechung des über Funkenstrecke $SG_{hc}$ bzw. Überbrückkungsschalter BS fließenden Hochstroms durch den Sicherheitsschalter MB als Abschluß der Ausschaltung des ersten CO-Zyklus mit anschließender Öffnung für die Einschaltung im zweiten CO-Zyklus

Alternativ kann eine Schaltfunkenstrecke $SG_{hc}$ mit vergrössertem Elektrodenabstand eingesetzt werden; ein Steuergerät $CD_{hc}$ zündet sie im Zeitbereich $t_1$ des Nulldurchgangs des resultierenden Stroms im Hilfsschalter $B_a$, wobei dieses Gerät an einen Stromwandler $CT_{hc}$ oder an einen nicht dargestellten Shunt angeschlossen ist.

Zünden im Zeitbereich $t_1$ bedeutet: zünden kurz vor dem Nulldurchgang oder im Nulldurchgang oder kurz nach dem Nulldurchgang des resultierneden Stroms im Hilfsschalter. Stromwandler $CT_{hc}$ oder entsprechender Shunt sind zwischen den Anschlußstellen des Hochspannungsschwingkreises I an den Hochstromkreis angeordnet, Fig. 6.

Die Elektroden der Schaltfunkenstrecken $SG_{hc}$ und $SG_{hv}$ können zur Minimierung der Lichtbogenerosion zumindest im Bereich der einander zugewandten Oberflächen aus zumindest graphithaltigem Material hergestellt sein. Nützlich ist es auch, die Elektroden allgemein schalenförmig auszubilden und daran in bekannter Weise bogenförmige Stromleiterabschnitte vorzusehen zur Rotation des Schaltlichtbogens in einem radialen Magnetfeld. Die Elektroden der Schaltfunkenstrecken $SG_{hc}$ und/oder $SG_{hv}$ können vorteilhaft auch in einem Isoliergas oder im Vakuum angeordnet sein.

Zur Verstärkung der Prüfleistung der erfindungsgemäßen synthetischen Prüfschaltung durch eine mit der Stromfolge in der Schaltstrecke des Prüfschalters korrespondierende Spannungsüberlagerung an dieser Schaltstrecke wird ein zweiter Hochspannungsschwingkreis II eingeführt mit folgenden Bauelementen: auf elektrisches Potential aufladbare Kapazität $\bar{C}_{hv}$ als Hochspannungsquelle in Reihenschaltung mit: Induktivität $\bar{L}_{hv}$ und Koppel- sowie Spannungsaufbaukapatäz $C_c$ mit parallelgeschaltetem ohmschen Widerstand $\bar{R}$.

Für die gesteuerte Zündung der Schaltfunkenstrecke $\overline{SG}_{hv}$ ist eine Meß- und Steuerfunkenstrecke MG (measuring sparc and control gap) vorgesehen; im Zünd- und Steuerkreis sind ohmscher Widerstand $R_m$ und Koppelkapazität $C_m$ angeordnet.

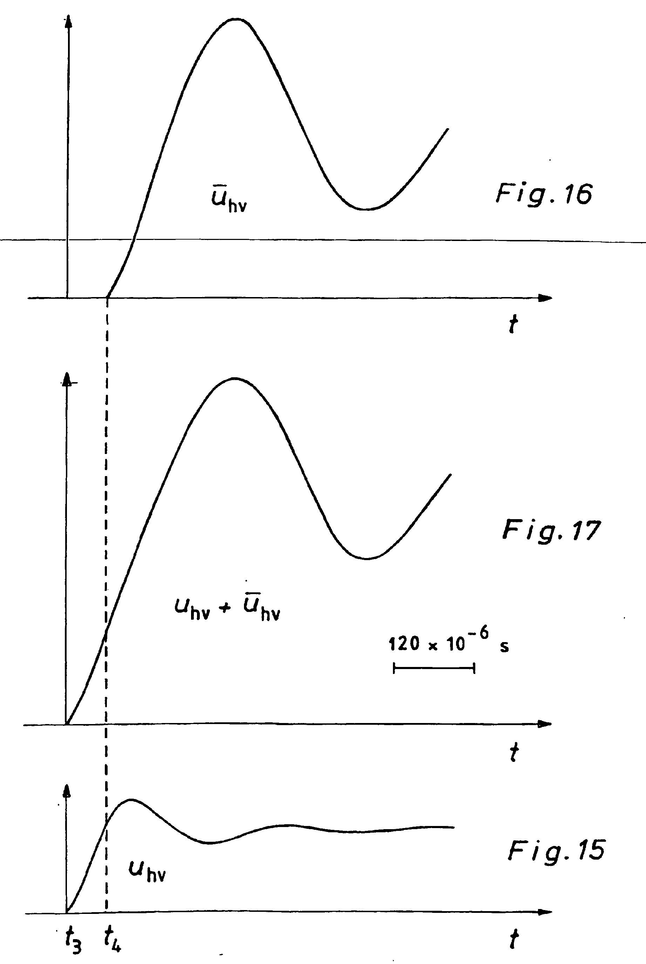

Die Koppel- und Spannungsaufbaukapazität $C_c$ ist einem zweiten Hilfsschalter $B_{aa}$ parallel geschaltet. Im Anwendungsfall wird dieser Schalter an Stelle der Leitungsnachbildung SLF oder damit in Reihe in den Hochspannungsschwingkreis I eingefügt; der Einbau kann auch im Stromleiterabschnitt des Hochspannungsschwingkreises I vor seiner zweiten Anschlußstelle an den Hochstromkreis erfolgen, Fig. 6, 14.

Der zweite Hilfsschalter wird so ausgelöst, daß er bis zum Nulldurchgang des Schwingstroms $i_{hv}$, Zeitpunkt $t_3$, Fig. 10, 12, eine ausreichende Stromunterbrechungsfähigkeit erlangt hat; dazu sind auch hier die bereits für den ersten Hilfsschalter $B_a$ empfohlenen Qualitäten nützlich. Alternativ kann als zweiter Hilfsschalter ein Schalter verwendet werden, dessen Schaltstrecke durch einen den Ausschaltlichtbogen einleitenden Schmelzdraht überbrückt ist.

Nach dem Nulldurchgang des Schwing- und Folgestroms schwingt die Spannung des Hochspan-

nungsschwingkreises I, $u_{hv}$, auf einen stationären Wert ein, Fig. 15; sie verteilt sich auf Prüfschalter $B_t$ und Hilfsschalter $B_{aa}$ im Verhältnis der Koppel- und Spannungsaufbaukapazität $C_c$ zur zehn bis hundert mal kleineren Eigenkapazität des Prüfschalters. Somit liegt die Spannung des Hochspannungsschwingkreises I fast vollständig an den Klemmen des Prüfschalters als erster Teil seiner Spannungsbeanspruchung.

Sobald ein bestimmter Spannungswert erreicht ist, Zeitpunkt $t_4$, Fig. 15, zündet die Meßfunkenstrecke MG. Der damit verbundene Hochspannungsimpuls am Widerstand $R_g$ wird über die Koppelkapazität $C_g$ an die Zündelektrode der Schaltfunkenstrecke $\overline{SG}_{hv}$ übertragen und zündet sie. Dann baut sich an der Koppelkapazität $C_c$ die Einschwingspannung $\overline{u}_{hv}$ des Hochspannungsschwingkreises II auf, Fig. 16. Die Summenspannung $(u_{hv} + \overline{u}_{hv})$, Fig. 17, durch zwei Parameter, Scheitelwert und Zeitdauer bis dahin, bestimmt, prüft die wiederkehrende Spannungsfestigkeit des Prüfschalters; sind beide Einschwingspannungen wenig gedämpft, Überschwingfaktor etwa 1,8, und verhalten sich ihre Anfangswerte $U_{hv}$, $\overline{U}_{hv}$ etwa wie 1: 0,3 , ergibt sich eine durch vier Parameter bestimmte Summenspannung, DIN VDE 0670, 1992-10, Teil 104, Bild 25.

Der zweite Hilfsschalter $B_{aa}$ mit parallelgeschaltetem Hochspannungsschwingkreis II kann auch im Hochstromkreis in folgenden, nicht dargestellten Positionen eingebaut sein: Im Stromleiterabschnitt zwischen der Anschlußstelle des Hochspannungsschwingkreises I an den Hochstromkreis, welcher der Prüfschalter unmittelbar nachfolgt und diesem Schalter oder im Stromleiterabschnitt zwischen der anderen Anschlußstelle des Hochspannungsschwingkreises I an den Hochstromkreis und der Spannung führenden Anschlußstelle der Schaltfunkenstrecke $SG_{hc}$.

In beiden Anordnungen des zweiten Hilfsschalters $B_{aa}$ haben die Einschwingspannungen der Hochspannungsschwingkreise I und II, $u_{hv}$ bzw. $\overline{u}_{hv}$, gleiche Polarität und addieren sich zur Summen-Einschwingspannung $(u_{hv} + \overline{u}_{hv})$, Fig. 15, 16, 17.

In einer dritten möglichen Einbauposition ist der zweite Prüfschalter $B_{aa}$ zwischen Prüfschalter $B_t$ im Stromleiterabschnitt zwischen Prüfschalter $B_t$ und der folgenden Nullpotential führenden Anschlußstelle der Hochstrom-Schaltfunkenstrecke $SG_{hc}$ an den Hochstromkreis angeordnet. Die Einschwingspannung des parallel angeschlossenen Hochspannungsschwingkreises II, $\overline{u}_{hv}$, weist als Veränderung nur-die entgegengesetzte Polarität gegenüber der Einschwingspannung $u_{hv}$ des Hochspannungsschwingkreises I auf. Die dielektrische Beanspruchung des Prüfschalters resultiert aus der Differenz dieser beiden. Eincshwingspannungen und sie zeigt denselben Verlauf wie die Summe der Einschwingspannungen $(u_{hv} + \overline{u}_{hv})$ in Fig. 17.

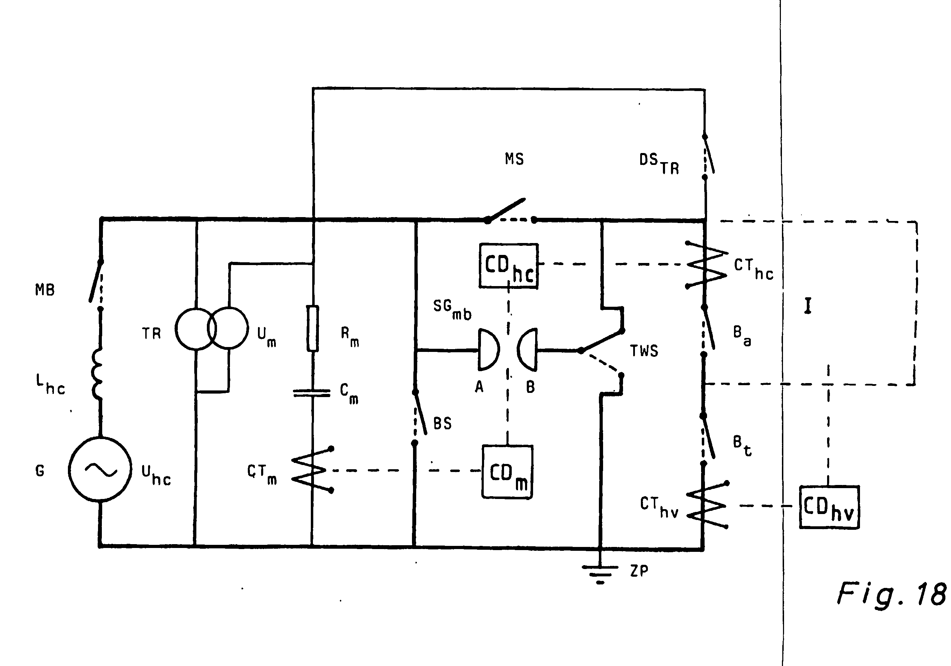

In der synthetischen Prüfschaltung zur Prüfung der Kurzschlußstrom-Einschaltleistung von Hochspannungs-Wechselstrom-Leistungsschaltern, Fig. 18, besteht der Hochspannungskreis im wesentlichen aus einem Hochspannungstransformator TR mit relativ sehr kleinem Kurzschlußstrom. Die Primärwicklung ist an den Hochstromgenerator G angeschlossen. Die Sekundär- und Hochspannungswicklung ist mit der Reihenschaltung einer Kapazität $C_m$ und eines ohmschen Widerstands $R_m$ belastet. Die mit der Spannung des Hochstromgenerators $U_{hc}$ synchrone Einschalt-Hochspannung $U_m$ (making high voltage) steht über den geschlossenen Trennschalter $DS_{TR}$ (disconnecting switch transformer circuit) an der Schaltstrecke des Prüfschalters an. Ein nicht dargestellter ohmscher Widerstand kann auch in der Verbindungsleitung des Hochspannungstransformators TR mit dem Prüfschalter $B_t$ angeordnet sein.

Außer dem Prüfschalter ist zu Beginn der Kurzschlußstrom-Einschaltprüfung noch der Draufschalter MS geöffnet. Auf der Generatorseite dieses Schalters ist die Elektrode A einer Zwei-Elektrodenfunkenstrecke $SG_{mb}$ an den Hochstromkreis angeschlossen. Die Elektrode B kann wechselweise mittels des Wechselschalters TWS (two way switch) an die andere Klemmenseite des Draufschalters angeschlossen werden oder mit Nullpotential ZP (zero potential) des Hochstromkreises verbunden sein; für die Prüfung der Kurzschluß-Einschaltleistung ist der zuerst genannte Anschluß die Wahl.

Die Spannungsfestigkeit des einschaltenden Prüfschalters nimmt entlang einer dielektrischen Einschaltcharakteristik $u_d$ (dielectric closing characteristic) ab. Im Schnitt mit der Einschaltspannung $u_m$ erfolgt ein Vorüberschlag, Zeitpunkt $t_o$, Fig. 19. Es fließt ein im wesentlichen aus dem $C_m$-$R_m$-Glied gespeister transienter Einschaltstrom $i_{tm}$ (transient initial making current). Dieser Strom löst durch ein an den Stromwandler $CT_m$ - auch ein Shunt ist verwendbar - angeschlossenes Zündgerät $CD_m$, Fig. 18, das Zünden der Schaltfunkenstrecke $SG_{mb}$ aus. Nach der Eigenzeit $t_d$ (time delay) dieser Steuer- und Schaltvorrichtung setzt der Hochstrom $i_{hc}$ zunächst sich dem $i_{tm}$-Strom überlagernd und danach als Folgestrom fließend ein, Fig. 20. Das Einschaltlichtbogeninterval mit der Lichtbogenspannung $u_a$, Fig. 19, dauert bis zur Kontaktberührung, Zeitpunkt $t_1$; ab $t_2$ sind die Kontakte des Prüfschalters verklinkt, Fig. 21. Kurze Zeit nach dem Vorüberschlag in der Schaltstrecke des Prüfschalters entlastet der Draufschalter MS die Hochstrom-Schaltfunkenstrecke. Den Hochstrom unterbricht der Sicherheitsschalter MS.

Nach abgeschlossener Prüfung der Kurzschlußstrom-Einschaltleistung und mittlerweile geöffnetem Trennschalter $DS_{TR}$ schließt der Wechselschalter TWS mittels eines programmiert steuerbaren Schalterantriebs die Elektrode B der Zwei-Elektrodenfunkenstrecke an Nullpotential des Hochstromkreises an, Fig. 18. In dieser Einbauposition arbeitet die Schaltfunkenstrecke $SG_{mb}$. während der folgenden Prüfung der Kurzschlußstrom-Ausschaltleistung als Vorrichtung für Hochstrom-Eliminierung aus dem und Schwingstrom-Transfer in den Prüfschalter $B_t$ wie bereits an früherer Stelle erläutert.

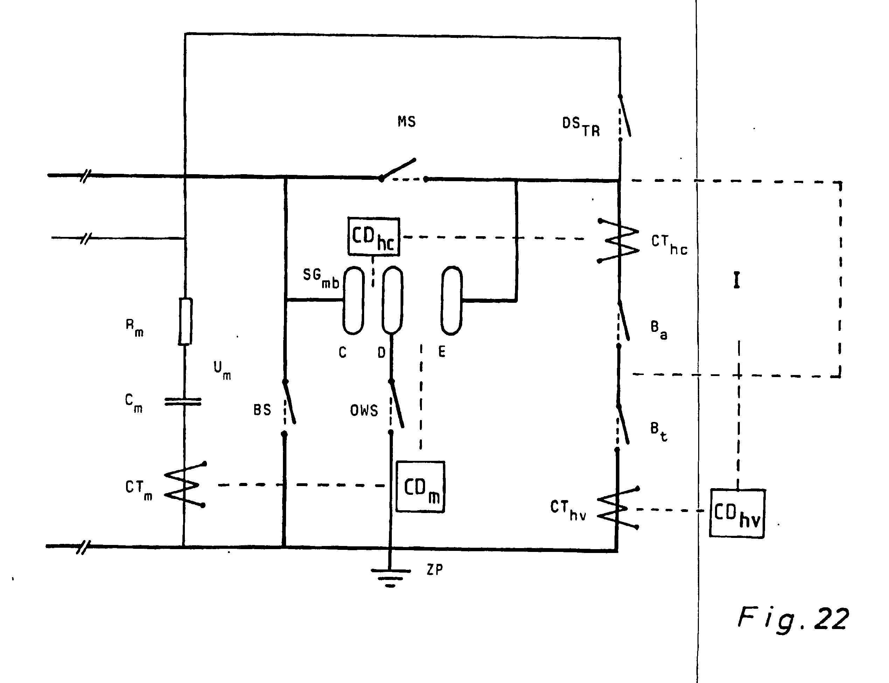

Fig. 22 zeigt den nur mehr das zum Verstehen Wesentliche enthaltenden Schaltplan der synthetischen Prüfschaltung zur Prüfung der Kurzschlußstrom-Einschaltleistung bei Verwenden einer Drei-Elektroden-Hochstrom-Schaltfunkenstrecke $SG_{mb}$.

Die Elektrode C ist auf der Hochstromgeneratorseite des Draufschalters MS an den Hochstromkreis angeschlossen; die Mittelelektrode D kann mittels eines Einwegschalters OWS (one way switch) mit dem Null Poterial aufweisenden Stromleiterabschnitt verbunden oder von diesem isoliert werden. Die Elektrode E ist auf der entgegengesetzten Einbauseite des Draufschalters mit dem Hochstromkreis verbunden.

Bei geschlossenem Trennschalter $DS_{TR}$ und geöffnetem Schalter OWS steht an der Drei-Elektrodenfunkenstrecke die Differenz der Spannungen $U_m$ des Hochspannungstransformators TR und $U_{hc}$ des Hochstromgenerators G an. Der Vorüberschlagsstrom in der Schaltstrecke des einschaltenden Prüfschalters, $i_{tm}$, Fig. 20, löst mittels des an den Stromwandler $CT_m$ angeschlossenen Zündgerätes $CD_m$ die Zündung der Drei-Elektrodenfunkenstrecke aus. Der weitere Stromverlauf im Prüfschalter entwickelt sich wie bereits im Fall der Zwei-Elektrodenfunkenstrecke erläutert. Und auch die Drei-Elektrodenfunkenstrecke wird kurz nach dem Vorüberschlag im Prüfschalter durch Schließen des Draufschalters MS vom Hochstrom $i_{hc}$ entlastet.

Für eine anschließende Prüfung der Kurzschlußstrom-Ausschaltleistung schließt zunächst der Schalter OWS. Die dann aus den Elektroden C und D bestehende Hochstrom-Schaltfunkenstrekke zündet im Zeitbereich $t_1$, Fig. 10, 12, des künstlichen Nulldurchgangs des Stroms im ersten Hilfsschalter $B_a$ das an den Stromwandler $CT_{hc}$ angeschlossene Zünd- und Steuergerät $CD_{hc}$; alle weiteren Schaltvorgänge laufen wie bei der schon erläuterten erfindungsgemäßen synthetischen Kurzschlußstrom-Ausschaltleistungsprüfschaltung ab.

Das Umschalten von Einwegschalter OWS, Draufschalter MS und Überbrückungsschalter BS - letzterer ist auch bei Anwendung der Zwei-Elektroden-Hochstrom-Schaltfunkenstrecke betriebsmäßig vorhanden, Fig. 18, und wird dort auch erst während der Ausschaltleistungsprüfung zur Hochstromentlastung dieser Funkenstrecke geschlossen - von den zuletzt eingenommenen Schaltpositionen bei der Einschaltleistungsprüfung in die einzunehmenden Anfangs-Schältpositionen bei der Ausschaltleistungsprüfung in dieser synthetischen General-Prüfschaltung und umgekehrt besorgt ein nicht dargestelltes Steuergerät nach vorgegebenem Programm.

## Patentansprüche

1. synthetische Schaltleistungsprüfschaltung für Hochspannungs- Wechselstrom- Leitungsschalter mit einem Hochstromkreis, der zumindest einer Hochstromquelle (G) in Reihenschaltung mit einem Prüfschalter ($B_t$) und mindestens einen Hilfsschalter ($B_a$) enthält, und einem vor dem Nulldurchgang der Halbschwingung eines Hochstroms an den Hochstromkreis zuschaltbaren, eine Hochspannungsquelle ($C_{hv}$) enthaltenden Hochspannungsschwingkreis (I), **gekennzeichnet durch** folgende Merkmale:

  der Hochspannungsschwingkreis ist im Verlauf der Hochstromhalbschwingung ($i_{hc}$) dem Hilfsschalter mittels einer Schaltvorrichtung ($SG_{hv}$) so parallelschaltbar sich dem Hochstrom im Hilfsschalter ein Schwingstrom ($i_{hv}$) des Hochspannungsschwingkreises mit entgegengesetzter Polarität daß überlagert und der resultierende Strom während der Halbschwingung des Hochstroms einen Nulldurchgang aufweist; Schaltmittel ($SG_{hc}$) die im Zeitbereich des Nulldurchgangs des resultierenden Stroms im Hilfsschalter den Hochspannungsschwingkreis unter Ausschluß des Hochstromkreises mit dem Prüfschalter in Reiheschalter, woraufhin der Schwingstrom in den Prüfschalter wechselt als Folgestrom des daraus eliminierten Hochstroms, und
  dieser Folgestrom ($i_{hv}$) im Prüfschalter geht mit zumindest angenähert derselben Steilheit gegen Null wie der synthetisch nachzubildende Hochstrom, woraufhin an der Schaltstrecke des Prüfschalters eine Spannung ($u_{hv}$) des Hochspannungsschwingkreises auf eine Endhöhe einschwingt.

2. Prüfschaltung nach Anspruch 1, **gekennzeichnet durch** folgende Merkmale:

  der Schwingstrom ($i_{hv}$) wird dem Hochstrom ($i_{hc}$) im Hilfsschalter ($B_a$) zu einem Zeitpunkt ($t_o$) mit entgegengesetzter Polarität überlagert, woraufhin der Schwingstrom mit einem Anfangswert gleich oder kleiner 95 % seines Scheitelwerts ($I_{hv}$) als Folgestrom des Hochstroms ($i_{hc}$) in den Prüfschalter ($B_t$) wechselt.

3. Prüfschaltung nach Anspruch 1, **gekennzeichnet durch** folgende Merkmale:

  ein zweiter Hilfsschalter ($B_{aa}$) ist angeordnet in einem Stromleiterabschnitt des Hochspannungsschwingkreises (I) oder im Hochstromkreis, und darin im Stromleiterabschnitt zwischen einer der beiden Anschlußstellen des Hochspannungsschwingkreises (I) an den Hochstromkreis und dem Prüfschalter ($B_t$) in diesem Kreis, oder im Stromleiterabschnitt zwischen der anderen Anschlußstelle des Hochspannungsschwingkreises (I) und der elektrisches Potential führenden Anschlußstelle der Hochstrom-Schaltfunkenstrecke ($SG_{hc}$), oder im Stromleiterabschnitt zwischen dem Prüfschalter ($B_t$) und der Nullpotential aufweisenden Anschlußstelle der Hochstrom-Schaltfunkenstrecke ($SG_{hc}$) an den Hochstromkreis, wobei dem zweiten Hilfsschalter in einer der genann-Anordnungen zumindest eine Kapazität ($C_c$) parallelgeschaltet ist und diese Kapazität sowie eine Reihenschaltung aus zumindest einer Induktivität ($\overline{L}_{hv}$) und einer auch eine Hochspannungsquelle darstellende Kapazität ($\overline{C}_{hv}$) zur Zeit eines bestimmten Wertes der Einschwingspannung ($u_{hv}$) des Hochspannungsschwingkreises (I) zu einem Hochspannungsschwingkreis (II) verbunden werden, dessen an dem zweiten Hilfsschalter erzeugte Einschwingspannung ($\overline{u}_{hv}$) in Summe bzw. in Differenz mit der Einschwingspannung ($u_{hv}$) des Hochspannungsschwingkreises (I) die Schaltstrecke des Prüfschalters ($B_t$) dielektrisch beansprucht.

4. Prüfschaltung nach Anspruch 1, **gekennzeichnet durch** folgende Merkmale:

   das Ausschalten des Hilfsschalters wird zeitlich so ausgelöst, daß die Trennung seiner Kontakte stattfindet kurze zeit vor Beginn einer Überlagerung, oder zu Beginn einer Überlagerung, oder kurze Zeit nach Beginn einer Überlagerung eines Hochstroms ($i_{hc}$) mit einem Schwingstrom ($i_{hv}$) in der Schaltstrecke des Hilfsschalters.

5. Prüfschaltung nach Anspruch 4, **gekennzeichnet durch** folgende Merkmale:

   die Kontakte des Hilfsschalters weisen bei der Trennung eine Relativgeschwindigkeit auf.

6. Prüfschaltung nach Anspruch 4, **gekennzeichnet durch** folgende Merkmale:

   im Hochstromkreis ist der Generator (G) ohne Zwischenschaltung eines Transformators oder mit Zwischenschaltung eines den Generatorstrom vergrößernden Transformators mit dem Hilfsschalter ($B_a$) und dem Prüfschalter ($B_t$) verbunden.

7. Prüfschaltung nach Anspruch 1, **gekennzeichnet durch** folge.nde Merkmale:

   eine Hochstrom-Schaltfunkenstrecke ($SG_{mb}$) ist als Bestandteil des Hochstromkreises abwechselnd parallelgeschaltet: einem im Hochstromkreis eingebauten Draufschalter (MS) bei der synthetischen Einschaltleistungs-Prüfschaltung, wobei das Zünden der Hochstrom-Schaltfunkenstrecke ein vom Einschaltstrom im Prüfschalter ausgelöstes Zündgerät ($CD_m$) bewirkt, oder mindestens einem Hilfsschalter in Reihenschaltung mit dem Prüfschalter bei der synthetischen AusschaltleistungsPrüfschaltung, wobei das Zünden der Hochstrom-Schaltfunkenstrecke ($SG_{mb}$) im Zeitbereich des Nulldurchgangs des resultierenden Stroms im Hilfsschalter erfolgt durch ein Zündgerät ($CD_{hc}$).

8. Prüfschaltung nach Anspruch 7, **gekennzeichnet durch** folgende Merkmale:

   die Hochstrom-Schaltfunkenstrecke ist als Zwei-Elektrodenfunkenstrecke ausgebildet, wobei die eine Elektrode (A) auf der Hochstromquellenseite des Draufschalters an den Hochstromkreis angeschlossen ist und die andere gegenübärliegende Elektrode (B) mittels einer Wechselschaltvorrichtung (TWS) mit der gegenüberliegenden Anschlußseite des Draufschalters verbunden ist, oder mit einem Nullpotential (ZP) aufweisenden Stromleiterabschnitt des Hochstromkreises in Parallelschaltung zu Hilfsschalter und Prüfschalter.

9. Prüfschaltung nach Anspruch 7, **gekennzeichnet durch** folgende Merkmale:

   die Hochstrom-Schaltfunkenstrecke ($SG_{mb}$) ist als Drei-Elektrodenfunkenstrecke ausgebildet, wobei die äusseren Elektroden (C) und (E) dem Draufschalter im Hochstromkreis parallelgeschaltet sind; wogegen die innere Elektrode (D) mittels einer Schaltvorrichtung (OWS) von einem Nullpotential (ZP) aufweisenden Stromleiterabschnitt des Hochstromkreises.isoliert ist, oder mit diesem Stromleiterabschnitt verbunden ist in Parallelschaltung zu Hilfsschalter und Prüfschalter.

**Claims**

1. A synthetic making/breaking-capacity test circuit for high-voltage alternating-current circuit- breakers with a high-current circuit, containing at least one high-current source (G) connected in series with a test circuit-breaker ($B_t$) and at least one auxiliary circuit-breaker ($B_a$), and a high-voltage oscillating circuit (I), containing a high-voltage source ($C_{hv}$) and connectable to the high-current circuit before the zero crossing of the partial oscillation of a high current, wherein
   during the high-current partial oscillation ($i_{hc}$), the high-voltage oscillating circuit is connected in parallel with the auxiliary circuit-breaker by means of a

switching device ($SG_{hv}$), whereupon an oscillating current ($i_{hv}$) of the high-voltage oscillating circuit is superimposed on the high current in the auxiliary circuit-breaker with opposite polarity and the resulting current exhibits a zero crossing during the partial oscillation of the high current;

switching devices ($SG_{hc}$) connect the high-voltage oscillating circuit in series with the test circuit-breaker, to the exclusion of the high-current circuit, during the time range of the zero crossing of the resulting current in the auxiliary circuit-breaker, whereupon the oscillating current is transferred in the test circuit-breaker as sequence current of the high current eliminated from said circuit-breaker;

the sequence current ($i_{hv}$) in the test circuit-breaker tends towards zero with at least approximately the same gradient as the high current that must be simulated synthetically, whereupon a voltage ($u_{hv}$) of the high-voltage oscillating circuit oscillates to an ultimate magnitude at the switching gap of the test circuit-breaker.

2. The test circuit of claim 1, wherein:

the oscillating current ($i_{hv}$) is superimposed on the high current ($i_{hc}$) in the auxiliary circuit-breaker ($B_a$) with opposite polarity at an instant ($t_0$), whereupon this oscillating current is transferred to the test circuit-breaker ($B_t$) with an initial value that is less than or equal to 95 % of its peak value ($I_{hv}$) as sequence current of the high current ($i_{hc}$).

3. The test circuit of claim 1, wherein:

a second auxiliary circuit-breaker ($B_{aa}$) is arranged either in a conductor section of the high-voltage oscillating circuit (1) or in the high-current circuit, and therein either in the conductor section between one of the two terminals of the high-voltage oscillating circuit (I) at the high-current circuit and the test circuit-breaker ($B_t$) in this circuit or in the conductor section between the other terminal of the high-voltage oscillating circuit (I) and the terminal of the high-current switching spark gap ($SG_{hc}$), which has electrical potential, or in the conductor section between the test circuit-breaker ($B_t$) and the terminal of the high-current switching spark gap ($SG_{hc}$) at the high-current circuit, which has zero potential, whereby at least one capacitance ($C_c$) is connected in parallel with the second auxiliary circuit-breaker in one of the above-mentioned configurations, and this capacitance as well as a series circuit comprising at least one inductance ($\overline{L}_{hv}$) and one capacitance ($\overline{C}_{hv}$), which may also act as a high-voltage source, are connected to a high-voltage oscillating circuit (11) synchronously with a defined value of the transient voltage ($U_{hv}$) of the high-voltage oscillating circuit (I); the transient voltage ($\overline{u}_{hv}$) of the high-voltage oscillating circuit (II), which is generated at the second auxiliary circuit-breaker, in the sum or difference with the transient voltage ($u_{hv}$) of the high-voltage oscillating circuit (I) exerts a dielectric stress on the switching gap of the test circuit-breaker ($B_t$).

4. The test circuit of claim 1, wherein:

the opening of the auxiliary circuit-breaker is timed such that its contacts are separated: just before an oscillating current ($i_{hv}$) starts to be injected into a high current ($i_{hc}$) or at the instant this oscillating current starts to be injected or just after this oscillating current starts to be injected in the switching gap of the auxiliary circuit-breaker.

5. The test circuit of claim 4, wherein the contacts of the auxiliary circuit-breaker have a relative speed at the instant of separation.

6. The test circuit of claim 4, wherein in the high-current circuit the generator is connected to the auxiliary circuit-breaker ($B_a$) and the test circuit-breaker ($B_t$), either without an interconnected transformer or with an interconnected transformer to increase the generator current.

7. The test circuit of claim 1, wherein: a high-current switching spark gap ($SG_{mb}$) is connected as a component of the high-current circuit in parallel alternately either to a making switch (MS) instaled in the high-current circuit, at the synthetic making capacity test circuit, whereby y a control device ($CD_m$) which is triggered by the current in the test circuit breaker causes the high-current switching spark gap to be fired, or to at least one auxiliary circuit-breaker connected in series with the test circuit-breaker, at the synthetic breaking capacity test circuit, whereby a control device ($SG_{hc}$) which is triggered by the current in the auxiliary y circuit-breaker causes the high-current switching spark gap to be fired.

8. The test circuit of claim 7, wherein the high-current switching spark gap takes the form of a two-electrode spark gap, whereby one electrode (A) is connected to the high-current circuit on the high-current source side of the making switch and the other, opposite, electrode B is connected by means of a two-way switch (TWS) either to the opposite terminal side of the making switch or to a conductor section of the high-current circuit with zero potential (ZP) in a parallel connection with the auxiliary circuit-breaker and the test circuit-breaker.

**9.** The test circuit of claim 7, wherein the high-current switching spark gap ($SG_{mb}$) takes the form of a three-electrode spark gap, whereby the outer electrodes (C) and (E) are connected in parallel with the making switch in the high-current; the inner electrode (D), on the other hand by means of a one-way switch (OWS), is either isolated from a conductor section of the high-current circuit with zero potential (ZP) or connected to this conductor section in a parallel connection with the auxiliary circuit-breaker and the test circuit-breaker.

**Revendications**

**1.** Circuit d'essai synthetique pour vérifier la capacité de fermeture/coupure des disjoncteurs à haute tension à courant alternatif
avec un circuit à courant fort, contenant au moins une source à courant fort (G) en série avec un disjoncteur en essai ($B_t$) et au moins un disjoncteur auxiliaire ($B_a$) et un circuit d'oscillation à haute tension (I) contenant une source à haute tension ($C_{hv}$) et connectable sur le circuit à courant fort avant le passage par zéro du courant fort **caractérisé en ce que**:

Au cours de la demi-periode du courant fort ($i_{hc}$) le circuit d'oscillation à haute tension est connectable en parallèle sur le disjoncteur auxiliaire au moyen d'un dispositif de couplage ($SG_{hv}$) de sorte qu'un courant d'oscillation ($i_{hv}$) du circuit à haute tension se superpose au courant fort dans disjoncteur auxiliaire avec une polarité contraire et que le courant résultant présente un passage par zéro au cours de la la demi-periode du courant fort;
des dispositifs de commutation ($SG_{hc}$) pendant la periode du passage par zéro du courant résultant dans le disjoncteur auxiliaire, connecttent en série le circuit d'oscillation à haute tension avec le disjoncteur en essai en excluant le circuit à courant fort, après quoi le courant d'oscillation est transféré dans le disjoncteur en essai comme courant de suite du courant fort ainsi éliminé et ce courant de suite ($i_{hv}$) dans le disjoncteur en essai se dirige vers zéro avec au moins approximativement la même décroissance que le courant fort etant à etre simulé synthetiquement, après quoi sur la distance entre contacts du disjoncteur en essai une tension ($u_{hv}$) du circuit d'oscillation à haute tension oscille à une hauteur ultime.

**2.** Circuit d'essai suivant la revendication 1, **caractérisé en ce que**:

le courant d'oscillation ($i_{hv}$) peut être superposé

au courant fort ($i_{hc}$) dans le disjoncteur auxiliaire ($B_a$) avec une polarité inverse à un moment ($t_o$), de sorte que le courant oscillant est transféré dans le disjoncteur en essai ($B_t$) avec une valeur initiale égale ou inférieure à 95 % de sa valeur de crête ($I_{hv}$) comme courant suivant du courant fort ($i_{hc}$).

**3.** Circuit d'essai suivant la revendication 1, **caractérisé en ce que**:

un second disjoncteur auxiliaire ($B_{aa}$) est disposé dans un segment de conducteur du circuit d'oscillation à haute tension (I) ou dans le circuit à courant fort, et par là dans le segment de conducteur entre l'un des deux points de connection du circuit d'oscillation à haute tension (I) sur le circuit de courant fort et le disjoncteur en essai ($B_t$) dans ce circuit, ou dans le segment de conducteur entre l'autre point de connection du circuit d'oscillation à haute tension (I) et le point de connection conduisant le potentiel de l'eclateur commandé à courant fort ($SG_{hc}$), ou dans le segment de conducteur entre le disjoncteur en essai ($B_t$) et le point de connection de l'eclateur commandé ($SG_{hc}$) sur le circuit de courant fort présentant le potentiel nul, de sorte qu'au moins une capacitance ($C_c$) est montée en paralléle au second disjoncteur auxiliaire dans l'une des configurations indiquées et que cette capacitance ainsi qu'un montage en série comprenant au moin une inductance ($\overline{L}_{hv}$) et une capacitance ($\overline{C}_{hv}$) pouvant egalement agir comme une source haute tension sont rélies à un circuit d'oscillation haute tension (II) au moment d'une certaine valeur de la tension transi transitoire de retablissement ($u_{hv}$) du circuit d'oscillation à haute tension (I). La tension transitoire de rétablissement ($\overline{u}_{hv}$) du circuit d'oscillation à haute tension (II) qui est engendrée sur le deuxieme disjoncteur auxiliaire, en somme ou en différence avec la tension transitoire de rétablissement ($u_{hv}$) du circuit d'oscillation à haute tension (I) sollicite diélectriquement l'espace entre les contacts ouverts du disjoncteur en essai ($B_t$).

**4.** Circuit d'essai selon la revendication 1, **caractérisé en ce que**:

la coupure du disjoncteur auxiliaire peut être déclenchée temporairement de sorte que la déconnexion de ses contacts intervient peu de temps avant le début d'une superposition ou au debut d'une superposition ou peu de temps après le debut d'une superposition d'un courant fort ($i_{hc}$) avec un courant d'oscillation ($i_{hv}$) dans l'espace entre les contacts du disjoncteur auxiliaire.

**5.** Circuit d'essai selon la revendication 4, **caractérisé en ce que**:

les contacts du disjoncteur auxiliaire présentent lors de la déconnection une vitesse relative.

**6.** Circuit d'essai selon la revendication 4, **caracterisé en ce que**:

dans le circuit de courant fort le générateur (G) est relié sans transformateur intercalé ou avec transformateur intercalé augmentant le courant du generateur à le disjoncteur en essai et à le disjoncteur auxiliaire.

**7.** Circuit d'essai selon la revendication 1, **caractérisé en** se que:

un éclateur commande' ($SG_{mb}$) à courant fort est monté alternativement en paralléle comme composant du circuit de courant fort: soi un enclencheur (MS) monté dans le circuit de courant fort dans le circuit d'essai synthetique pour verifier la capacité de fermeture sur un court circuit, dans quel cas l'allumage de éclateur commandé à courant fort induit un appareil d'allumage ($CD_m$) déclenché par le courant de fermeture dans le disjoncteur en essai, soit au moins un disjoncteur auxiliaire monté en série avec le disjoncteur en essai dans le circuit d'essai synthetique pour vérifier la capacité de coupure, dans quel cas l'allumage de l'éclateur commandé ($SG_{hc}$) intervient au moment du passage à zero du courant fort dans le disjoncteur auxiliaire.

**8.** Circuit d'essai selon la revendication 7, **caractérisé en ce que**:

l'éclateur commande de courant fort est configuré comme un eclateur à etincelle à deux électrode, de sorte qu'une électrode (A) est racordée du côté source de courant fort de l'enclecheur au circuit de courant fort et que l'autre électrode (B) en face est connectée au moyen d'un dispositif de couplage à commutation (TWS) au côté opposé de l'enclecheur ou par un segment de conducteur du circuit de courant fort à potentiel zero (ZP) en montage en paralléle avec le disjoncteur auxiliaire et le disjoncteur en essai.

**9.** Circuit d'essai selon la revendication 7, **caractérisé en ce que**:

l'eclateur commandé de courant fort ($SG_{mb}$) est configuré comme un éclateur à étincelle à trois électrode, de sorte que les électrodes extérieures (C) et (E) sont montées en paralléle sur l'enclencheur dans le circuit de courant fort; par contre l'électrode intérieure (D) est isolée d'un segment de conducteur à potentiel zero (ZP) du circuit de courant fort au moyen d'un dispositif de couplage (OWS) ou est reliée à ce segment de conducteur en montage en paralléle avec le disjoncteur auxiliaire et le disjoncteur en essai.

Fig. 1

Fig. 2

$i_{hc}$

$t_1$  $t_2$

Fig. 3

$i_{hv}$

$t_0$  $t_1$  $t_3$

Fig. 4

$i_{hc}$

$i_{hv} / B_t$

$t_1$  $t_2 t_3$

Fig. 5

$u_{hv}$

$t_3$

14

Fig. 14

Fig. 6

Fig. 7

$i_{hc} / B_a$

$t_0$  $t_1$  $t_2$

$0.83 \times 10^{-3}$ s

$i_{hv} / B_a$

Fig. 8

$t_0$  $t_1$  $t_3$

Fig. 10

$u_{hc}$  Fig. 9

$t_1$  $t_z$

$i_{hc} / B_t$

$0.87 \, \hat{I}_{hv}$

$i_{hv} / B_t$

$t_1$  $t_2$  $t_3$

Fig. 11

$u_{hv}$

$t_3$

*Fig.12*

Fig. 13

EP 1 260 823 B1

*Fig.16*

$\bar{u}_{hv}$

*Fig.17*

$u_{hv} + \bar{u}_{hv}$

$120 \times 10^{-6}$ s

*Fig.15*

$u_{hv}$

$t_3$ $t_4$

Fig. 18

Fig.19

Fig.21

Fig.20

Fig. 22

EP 1 260 823 B1